# EUROPEAN PATENT APPLICATION

(11) **EP 1 389 897 A1**
(43) Date of publication of application: **18.02.2004**
(21) Application number: 02718637.8
(22) Date of filing: 23.04.2002
(51) Int. Cl.: H05K 1/11, H05K 3/40, H05K 3/46, H01L 23/12, H01L 23/52, H01L 25/065

(54) **PRINTED CIRCUIT BOARD, ITS MANUFACTURING METHOD, AND CSP MANUFACTURING METHDO**

(30) Priority: 24.04.2001 JP 2001126018; 17.05.2001 JP 2001147781
(71) Applicant: Mitsui Mining & Smelting Co., Ltd., Tokyo 141-8584 (JP)
(72) Inventor: ICHIRYU, Akira, c/o MITSUI MINING & SMELTING CO., Ageo-shi, Saitama 362-0021 (JP); HAYASHI, Katsuhiko, c/o MITSUI MINING & SMELTIN, Ageo-shi, Saitama 362-0021 (JP); KATAOKA, Tatsuo, c/o MITSUI MINING & SMELTING CO., Ageo-shi, Saitama 362-0021 (JP); KAWAMURA, Hirokazu, c/o MITSUI MINING & SMELTING, Ageo-shi, Saitama 362-0021 (JP); ISHII, Masahito, c/o MITSUI MINING & SMELTING CO., Ageo-shi, Saitama 362-0021 (JP)
(74) Representative: Pätzold, Herbert, Dr.-Ing.
(86) International application number: PCT/JP2002/004016
(87) International publication number: WO 2002/089540

(57) **Abstract**

A print circuit board including an insulation substrate, through-holes perforated through the insulation substrate, an implanting material filled in the through-holes, wired patterns formed on both surfaces of the insulation substrate, electrically connected with each other by the implanting material, and a conductor wired layer, one surface of which is electrically connected to the implanting material, having a bump penetrating from the one surface thereof to the other surface thereby forming a projection on the other surface. The conductor wired layer having the bump of the print circuit board has a lager degree of freedom in forming the wire pattern, the through-holes and the bump. Further, the conductor wired layer can be handled separately from the insulation substrate different from a conventional print circuit board. Accordingly, it is available by itself in the market.

## Description

### Technical Field

The present invention relates to a print circuit board, a method for fabricating the same and a method for fabricating a chip size package (CSP) formed by stacking the print circuit boards ("CSP formed by stacking the print circuit boards" will be hereinafter referred to simply as "CSP"), and more specifically relates to the print circuit board fabricated by integrating wiring patterns formed separately from a dielectric substrate with the said dielectric substrate, the method for fabricating the same, and the method for fabricating the CSP with a higher productivity.

### Background Art

Various circuit boards are used having conductor layers (wiring patterns) on their top and bottom surfaces. Concrete examples thereof includes a multi-layered wiring board using a rigid substrate made of glass epoxy in addition to a TAB (Tape Automated Bonding) tape using flexible polyimide resin as a substrate, CSP (Chip Size Package), BGA (Ball Grid Array) and FPC (Flexible Printed Circuit).

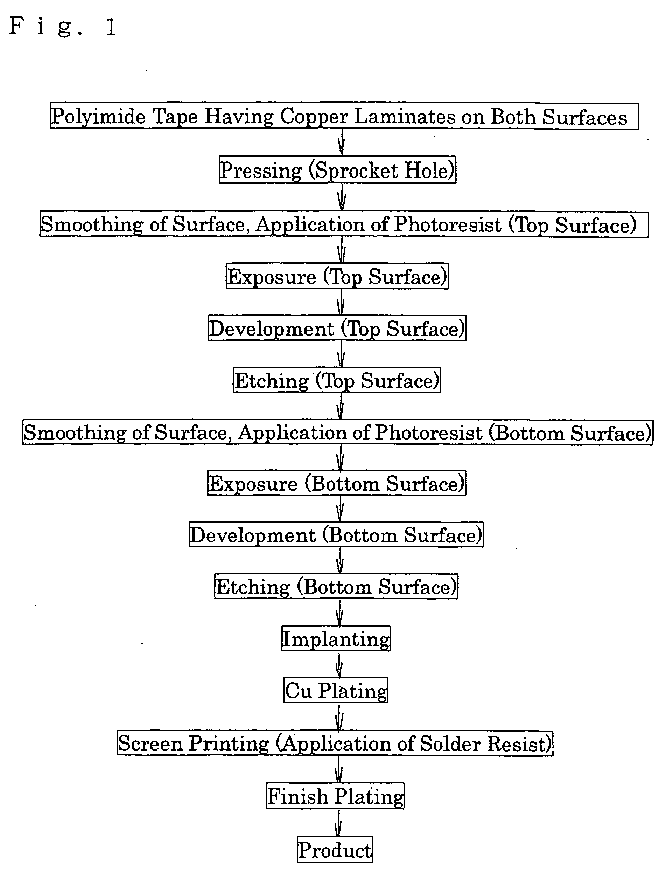

The printed circuit board having the wiring patterns on their top and bottom surfaces is fabricated in accordance with the conventional steps illustrated in a flow chart shown in Fig.1.

At first, sprocket holes are formed through specified positions of a tape made of polyimide film having laminated copper on both surfaces by means of pressing. Then, after the smoothing of the top surface of the polyimide tape, the photoresist is applied to the top surface of the film in accordance with a desired wired pattern followed by its exposure and development to fabricate an etching mask. The copper on the surface of the film is etched by using the mask to form the wired pattern thereon. Similarly, a wired pattern on the bottom surface of the polyimide tape is formed by the same procedure of the surface smoothing, the photoresist application, the exposure, the development and the etching.

Through-holes are perforated at specified positions of the polyimide tape having the wired patterns on the top and bottom surfaces thereof by using a punch-pressing machine. Then, materials such as tin-silver alloy materials and tin-copper alloy materials are superposed on the top and bottom surfaces of the polyimide tape, and embedded in the through-holes by means of the caulking attained by using the punch-pressing machine once again, thereby electrically connecting the wired patterns on the top and bottom surfaces with each other. The print circuit board having the ideal electrical connections can be obtained by embedding the tin-silver alloy material in the through-holes having a diameter of about 100 µm.

However, in the print circuit board thus obtained, the conductor wired layer on which the wired pattern is formed is integrated with the insulation substrate in advance. Accordingly, a series of steps including the formation of the wired patterns on the print circuit board should be conducted with the insulation substrate, thereby reducing the degree of freedom for handling. Further, when the conductor wired layer with the wired pattern can be available by itself in the market, it will attract new customers.

The CSP may be fabricated with a plurality of the stacked print circuit boards. If a longer period of time is required to fabricate the unit print circuit boards constituting the CSP, the productivity of the entire CSP is reduced, and this tendency is more noticeable when the number of the unit print circuit boards is increased.

### Disclosure of Invention

Accordingly, an object of the present invention is to provide a print circuit board in which a wired pattern can be formed separately from an insulation substrate, a conductor wired layer which is a precursor of the print circuit board, processes of fabricating these elements, and a process of fabricating CSP with higher productivity than that of prior art.

The present invention is a print circuit board including an insulation substrate having through-holes perforated therethrough, an implanting material filled in the through-holes, wired patterns formed on both surfaces of the insulation substrate, electrically connected with each other by the implanting material, and a conductor wired layer, one surface of which is electrically connected to the implanting material, having a bump penetrating from the one surface thereof to the other surface thereby forming a projection on the other surface. A conductor wired layer for the print circuit board which is a precursor of the print circuit board is also included in the present invention. The conductor wired layer may be used by itself or may be used after the integration with a resin layer. The print circuit board formed only with the conductor wired layer can be fabricated by forming an opening through a conductor wired layer, adhering a conductor layer for forming a bump on one surface of the conductor wired layer, entering the conductor layer for forming the bump in the opening for filling the opening therewith, and projecting the conductor layer for forming the bump from the other surface of the conductor wired layer to form a bump.

The present invention is a method of fabricating CSP including the steps of placing a conductive material for forming a bump near a substrate of a print circuit board, punching the conductive material and the substrate, simultaneously with the punching, to form though-holes in the substrate and to fill the through-holes with the conductive material, thereby fabricating a unit print circuit board having a desired number of bumps in the substrate, stacking a plurality of the unit print circuit boards sandwiching connecting members, and pressing the stacked unit print circuit boards under heating.

At first, the print circuit board and the method of fabricating the same will be described.

The print circuit board in accordance with the present invention is characterized by separately fabricating the conductor wired layer and the insulation substrate. While the fabricated conductor wired layer may be separately handled, it is eventually adhered to the insulation substrate for integration.

The material of the print circuit board of the present invention may be those used as the substrate in the conventional print circuit board without limitation, and, for example, polyimide resin is preferably used. The material of the conductor wired layer for forming the wired pattern and the method for forming the wired pattern are not especially restricted. The desired wired pattern can be obtained by the smoothening of the surface of a laminated copper layer, and the application of photoresist for masking, followed by the exposure, the development and the etching. If required, a similar wired pattern may be formed on the other surface of the print circuit board to fabricate the print circuit board having the wired patterns on the both surfaces.

In the method of the present invention, the through-hole formation and the filling of the through-holes with the conductive material (implanting material) are performed before the integration of the conductor wired layer with the insulation substrate. The number of the through-holes depends on the number of the wired patterns requiring the electric connection and the positional relation among them, and the diameter thereof is desirably as small as possible in the range of securing the sufficient electric connection.

The conductive material for filling the through-holes includes oxygen free high conductivity copper, phosphorous deoxidized copper and tough pitch copper in addition to the conventional metal copper.

The oxygen content of the oxygen free high conductivity copper is 0.005 % or less for preventing the hydrogen brittleness. The oxygen free high conductivity copper abbreviated to OFHC is prepared in a vacuum melting furnace or an induction furnace having a reduction atmosphere.

The phosphorous deoxidized copper having an extremely low oxygen content and containing a slight amount of remaining phosphorous is obtained by deoxidizing the oxygen in copper as an oxide such as P₂O₅.

Further, the tough pitch copper contains a small amount (0.02 to 0.05 %) of copper as Cu₂O and is obtained, as purified copper, by melting and purifying electrolytic copper in a reverberatory furnace to remain about 0.02 % of oxygen and then removing impurities such as As, Sb and P as their oxides out of the solid solution.

These coppers usually contain about 0 to 0.05 % of the oxygen and a smaller amount of other impurities, and has a higher heat resistance than a tin-silver alloy material and a tin-copper alloy material conventionally employed for filling the through-holes thereby elevating the heat resistance of the print circuit board at 260°C which is a re-flow temperature at the time of mounting solder balls. The effects are further increased when annealed oxygen free high conductivity copper, annealed phosphorous deoxidized copper and annealed tough pitch copper subjected to annealing in advance are used.

The punching preferably employed in the through-hole formation and the conductive material filling may be conducted similarly to the conventional punching. Although the procedures themselves are simple, the attention should be paid to (1) the relation, between the thickness of the conductive material (t1) excluding the projection and the thickness of the insulation sheet (t2) of the unit substrate; and (2) the selection and the establishment of post-treatments such as caulking.

The relation between the thickness of the conductive material (t1) and the thickness of the insulation sheet (t2) has the optimum region, preferably 1.4 x t2 ≧ t1 ≧ 0.7 x t2, and more preferably 1.2 x t2 ≧ t1 ≧ 0.9 x t2. The excessive thickness of the insulation sheet produces the concavo-convex on the surface to reduce the dimensional accuracy. The excessively thinner insulation substrate may produce the insufficient electrical connection with the wired pattern.

The caulking which affects the reliability of the conduction of the through-holes filled with the conductive material fixes the conductive material in the through-holes in accordance with a conventional method not to generate the positional displacement and the dropout.

The conductor wired layer having the wired pattern possesses a bump projecting from the conductor wired layer. The conductor wired layer is preferably a copper foil having a thickness of 15 to 20 µm.

The bump formation on the conductor wired layer is desirably conducted as follows.

At first, a plurality of openings are perforated through the conductor wired layer by using a metal mold such as a punch. The diameter may be nearly the same as the diameter of the bump and is usually about 100 µm.

Then, a conductor layer for bump formation is attached on one surface of the conductor wired layer having the openings, and the conductor layer for bump formation is entered into the openings of the conductor wired layer by using the punch for projecting a part of the conductor layer from the other surface. An amount of the projection may be determined depending on its usage and is usually about 100 µm.

The conductor wired layer having the plurality of the bumps is desirably caulked. The caulking enables the heights of the plurality of the bumps to be uniform, secures the bonding between the bumps and the conductor wired layer and aligns the base end surface of the bump with the surface of the conductor wired layer, thereby fabricating the conductor wired layer with the bumps.

While the opening is formed only through the conductor wired layer in the foregoing description, the opening formation and the bump formation can be conducted similarly after an adhesive resin layer is adhered to the surface of the conductor wired layer having the bump projection. An adhesive resin layer is added to the bump-side surface of the conductor wired layer having the bumps fabricated in this manner, and the conductor wired layer having the bumps is easily adhered to another element. The adhesive resin layer may be also formed on the surface of the conductor wired layer having no projecting bumps.

While the conductor wired layer having the bumps fabricated in this manner can be available by itself in the market, it is preferably adhered to the insulation substrate by using an adhesive agent to provide the print circuit board. The adhesive agent is desirably pre-preg or thermosetting resin which is not completely hardened. In addition, hot melt type resin or thermoplastic resin is also employable.

Even if the conductor wired layer having the bumps is adhered to the insulation substrate, the bumps of the conductor wired layer and the wired patterns are not necessarily connected to the conductive material in the through-holes of the insulation substrate with the sufficient electric connection. Accordingly, the connection may be conducted after a plated layer is formed on the entire surfaces or part of the conductor wired layer having the bumps, or the insulation substrate to which the conductor wired layer having the bumps is adhered is re-flown to alloy the interface between them for further securing the electric connection.

The wired patterns can be formed on the surface of the conductor wired layer at any time point, that is, before the opening formation, after the accomplishment of the conductor wired layer having the bumps or after the integration of the conductor wired layer having the bumps with the insulation substrate. The wired patterns of the conductor wired layer having the bumps of the present invention can be formed regardless of the number and the position of the through-holes so that the degree of freedom for forming the wired patterns is elevated. When the wired patterns are formed after the completion of the conductor wired layer having the bumps or after the integration of thereof with the insulation substrate, the wired patterns can be formed while easily comprehending the positions of the bumps because the bumps are already formed.

The print circuit of the present invention is applicable not only to a TAB tape, CSP, BGA and FPC or the like using a flexible circuit board but also to various print circuit boards using a rigid circuit board made of glass epoxy.

The wired pattern formation of the print circuit board of the present invention having the above-described configuration can be conducted also after the integration of the conductor wired layer with the insulation substrate. At this stage, only the plurality of the bumps other than the conductor wired layer itself are present on the conductor wired layer on which the wired patterns are to be formed. When, accordingly, the wired patterns are formed before the formation of the through-holes and the bumps similarly to a conventional method, the formation of the through-holes and the bumps can be performed without interference with the wired patterns so that the wired pattern formation and the through-hole and bump formation can be performed with a relatively higher degree of freedom.

While the conductor wired layer for the print circuit board of the present invention may be integrated with the insulation substrate, the conductor wired layer can be available by itself in the market, or can be integrated by being adhered to any part of the insulation substrate, different from the conventional print circuit board, because it is handled by itself.

As described earlier, when the plated layer is formed on the surfaces of the bumps and/or the conductor wired layer of the conductor wired layer for the print circuit board, the electric connection of the bump and the conductor wired layer with the conductive material in the through-holes of the insulation substrate can be further improved if the conductor wired layer is integrated with the insulation substrate.

In the method of fabricating the print circuit board of the present invention, the print circuit board having the adhesive resin layer can be obtained only by adding the adhesive resin layer to the conductor wired layer before establishing the electrical connection. In addition to the effects realized by the print circuit board itself, the fixation to another element is easily performed by means of the adhesive resin layer.

The conductor wired layer is used in the print circuit board and includes the bumps, the conductor wired layer and the resin layer, and the bumps penetrate from the conductor wired layer side to the resin layer side and project from the surface of the resin layer surface. Since this conductor wired layer can be handled by itself similarly to the conductor wired layer without the resin layer, it can be available by itself in the market and can be integrated by adhering to any part of the insulation substrate. Especially, the fixation to another element is more easily performed by means of the adhesive resin layer.

In this conductor wired layer similar to the conductor wired layer without the resin layer, a conductor thereof is a metal, an alloy or a cladding material. Further, a plated layer may be formed on the bumps and the conductor wired layer.

With connection to the conductor wired layer for the print circuit board of the present invention, the bumps may be formed by filling the openings perforated in advance with the conductor layer for bump formation, or by means of the simultaneous opening formation and opening filling. The former is preferable for the formation of the conductor wired layer having the accurate shape, and the latter is preferable in connection with the operation efficiency.

The plurality of the bumps are desirably caulked during the fabrication of the conductor wired layer, thereby enabling the heights of the plurality of the bumps to be uniform.

Also in this fabrication method, a plated layer is preferably formed on the bumps and/or the conductor wired layer after the bump formation for further securing the electric connection with the through-holes.

The plurality of the above print circuit boards can be stacked to provide a multi-layered print circuit board.

Then, a method of fabricating CSP which is another embodiment of the present invention will be described.

In accordance with the method of fabricating CSP of the present invention, the CSP can be fabricated with higher productivity, in other words, in a shorter period of time or with easier procedures.

The material of the print circuit board used in the method of fabricating the CSP of the present invention may be those used as the substrate in the conventional print circuit board without limitation, and, for example, polyimide resin is preferably used. The material of the wired pattern and the method for forming the wired pattern are not especially restricted. The desired wired pattern can be obtained by the smoothening of the surface of a laminated copper layer, the application of photoresist for masking, the exposure, the development and the etching. If required, a similar wired pattern may be formed on the other surface of the print circuit board to fabricate the print circuit board having the wired patterns on the both surfaces.

In the method of fabricating the CSP of the present invention, the step of forming the though-holes in the unit print circuit board and the step of filling the through-holes with the conductive material (implanting material) are simultaneously performed in effect. In order to simultaneously conducting the two steps, a three-stage operation is required, that is, molding (or hollowing out) the conductive material for filling the through-holes to the shape for the through-hole filling, penetrating the through-holes having the shape the same as the above molded material, and filling the through-holes with the molded material. The operation can be conducted by means of, for example, punching using a punch having the same shape as that of the through-holes to be formed.

For example, the conductive material molded to a plate-like shape is placed above the substrate. The punch is pressed to the surface of the conductive material corresponding to the point of the substrate where the through-holes are perforated, thereby hollowing out the conductive material. When the punch is lowered, the punch is in contact with the substrate to perforate the through-holes and to simultaneously and automatically fill the through-holes with the hollowed-out conductive material accompanied with the punch, thereby forming the bumps. The bump preferably has a projection from the surface having no wired patterns, and a preferable length of projection is between 10 and 30 µm.

In this manner, the unit print circuit board having the through-holes filled with the conductive material can be obtained easier than the conventional method. An integrated circuits is mounted on the unit print circuit board thus fabricated. The CSP obtained by stacking a plurality of the unit print circuit boards can be efficiently fabricated by the length of time obtained by multiplying the shortened length of time for fabricating each of the unit print circuit boards by the number of the unit print circuit boards.

The number of the through-holes formed in the substrate in the method of fabricating the CSP of the present invention depends on the number of the wired patterns requiring the electric connection and the positional relation among them, and the diameter thereof is desirably as small as possible in the range of securing the sufficient electric connection.

The conductive material for filling the through-holes includes oxygen free high conductivity copper, phosphorous deoxidized copper and tough pitch copper.

An adhesive layer may be laminated or a plated layer made of copper, gold, tin or its alloy may be formed on the unit print circuit board thus fabricated. The adhesive layer is effective for the connection between each of the unit print circuit boards and connecting elements during the fabrication of the CSP hereinafter described. The adhesive agent is desirably pre-preg or thermosetting resin which is not completely hardened. In addition, hot melt type resin or thermoplastic resin is also employable.

Then, the plurality of the unit print circuit boards are stacked while sandwiching the connecting elements to fabricate the CSR The connecting element has a function of electrically connecting the respective ,unit print circuit boards while insulating the integrated circuits mounted on the unit print circuit boards. A frame having an opening corresponding to the integrated circuits or solder balls for connecting the bumps of the adjacent unit print circuit boards is used as the connecting element.

The CSP is fabricated by pressing the plurality of the unit print circuit boards under heating after the stacking. The heating condition is not especially restricted unless harmful effects are not exerted on the unit print circuit boards and the connecting elements, and the heating is conducted usually at 170 to 180°C. The adhesive agent is melted with the heat to integrate the respective unit print circuit boards and the connecting elements.

In the fabrication method of the CSP of the present invention, the through-hole formation and the filling of the through-hole with the conductive material which are heretofore separately conducted can be conducted in a single operation during the fabrication of the respective unit print circuit boards. Accordingly, the respective unit print circuit boards can be fabricated easily or in a shorter period of time so that the CSP can be efficiently fabricated by the length of time obtained by multiplying the shortened length of time for fabricating each of the unit print circuit boards by the number of the unit print circuit boards.

The simultaneous conducting of the through-hole formation and the filling of the through-hole with the conductive material can be preferably performed by punching which uses a punch. When the bumps of the respective unit print circuit boards are projected in the same direction, the respective bumps and the adjacent connecting element are easily connected.

### Brief Description of Drawings

Fig.1 is a flowchart showing procedures of fabricating a conventional print circuit board.
Figs.2A to 2F are longitudinal sectional views exemplifying an embodiment of a series of procedures for fabricating a conductor wired layer having bumps in accordance with the present invention.
Figs.3A to 3F are longitudinal sectional views exemplifying an embodiment of a series of procedures for fabricating another conductor wired layer having bumps in accordance with the present invention.
Figs.4A to 4E are longitudinal sectional views exemplifying an embodiment of a series of procedures for fabricating a wired substrate employable in the present invention.
Fig.5 is a longitudinal front sectional view showing a positional relation between the unit print circuit boards of Fig. 4 and a frame for stacking the unit print circuit boards.
Fig.6 is a longitudinal front sectional view showing an embodiment of CSP of the method of the present invention.
Fig.7 is a longitudinal front sectional view showing another embodiment of CSP of the method of the present invention.

### Best Mode for Implementing Invention

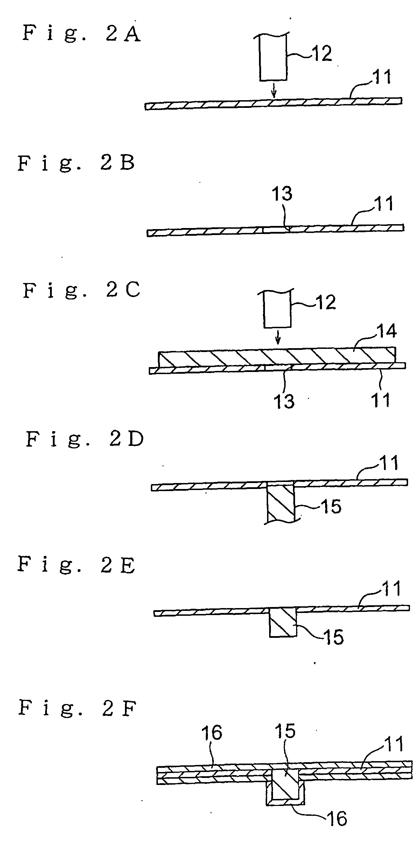

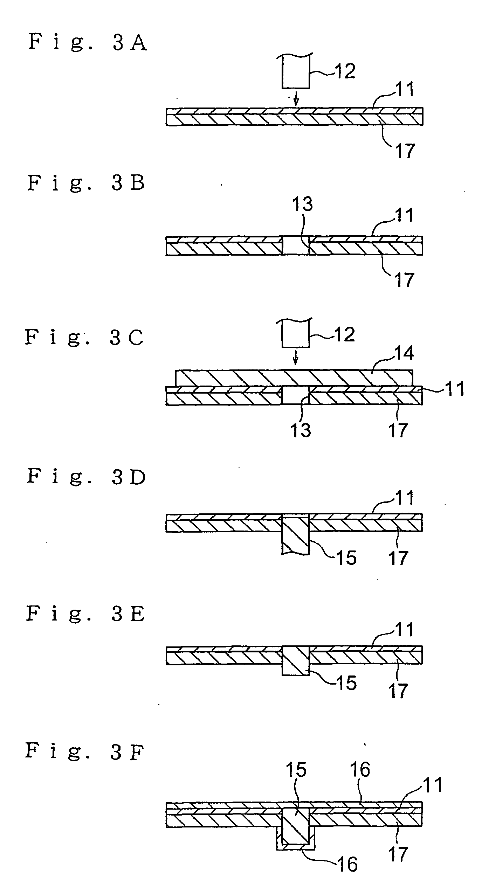

Although embodiments of fabricating a print circuit board of the present invention will be described based on Figs.2 and 3, the present invention shall not be deemed to be restricted thereto.

Through a conductor wired layer (copper foil) 11 having a thickness of about 18 µm and a desired wired pattern in advance shown in Fig.2A, an opening 13 of about 100 µm is perforated by using a punch 12 (Fig.2B).

Then, after a conductor layer 14 for forming bump made of, for example, metal copper is positioned on the copper foil 11 having the opening 13 (Fig.2C), a certain position of the conductor layer 14 corresponding to the opening 13 is pressed by using the punch 12 so that the conductor layer 14 is entered into the opening 13 and further a bump 15 is projected from the bottom surface of the conductor wired layer 11 as shown in Fig.2D. In addition, the opening formation and the bump formation may be conducted in a single operation by superposing the conductor layer for forming bump on the conductor wired layer before the opening formation and entering the conductor layer into the conductor wired layer by using the punch.

The conductor wired layer 11 having a plurality of the bumps 15 is caulked such that the heights of the bumps from the bottom surface of the conductor wired layer 11 is made to be uniform and the top surface of the bump 15 is aligned with the top surface of the conductor wired layer 11 (Fig.2E).

Then, copper or nickel-gold plating is conducted on the caulked conductor wired layer 11 to provide the conductor wired layer having plated layers with a thickness of about 3 µm on the top and bottom surfaces.

The conductor wired layer thus fabricated is integrated to an insulation substrate having through-holes (not shown) by means of adhesion to accomplish a print circuit board.

In another embodiment shown Figs.3A to 3F, an adhesive resin layer 17 is adhered on the bottom surface of the conductor wired layer 11 before the opening formation by using the punch (Fig.3A). Thereafter, similarly to the above embodiment, a conductor wired layer having bumps including the adhesive resin layer 17 on the bump-projecting surface can be fabricated by way of opening 13 formation (Fig.3B), placement of the conductor layer 14 for forming bumps (Fig.3C), bump 15 formation (Fig. 3D), caulking (Fig.3E) and plated layer 16 formation (Fig.3F).

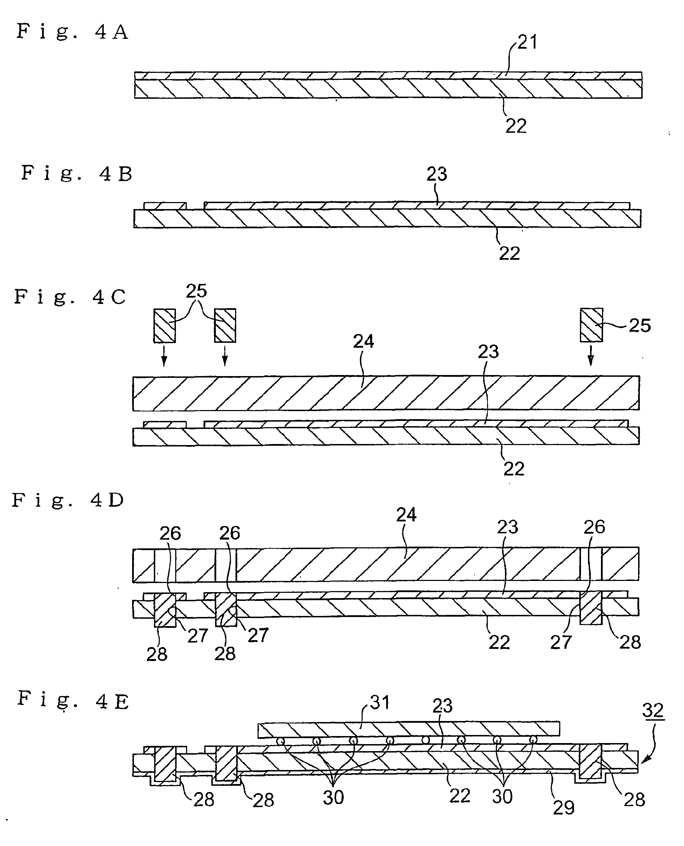

Although an embodiment of fabricating CSP will be described based on Figs.4 to 7, the present invention shall not be deemed to be restricted thereto.

As shown in Fig.4A, a substrate 22 is made of a polyimide film having a copper-laminated layer 21 on its one surface. The copper-laminated layer 21 is patterned to form wired patterns 23 (Fig.4B). Then, a plate-like conductive material 24 the same quality as an implant material for filling through-holes is positioned above the polyimide film 22. As shown in Fig.4C, punches 25 having the sectional shapes the same as those of openings are positioned above the plate-like material and corresponding to the through-holes. Then, as shown in Fig.4C, these punches 25 moves downward.

Each of the punches 25 penetrates the plate-like material 24 to hollow out the plate-like material as a pillar-like material having a sectional shape the same as that of the punch 25, and the pillar-like material is further moved downward by the punch 25. The punches 25 moving downward with the pillar-like material penetrate through-holes 26 and 27 through the wired patterns 23 and the polyimide film 22, respectively, and fill the through-holes 26 and 27 with the pillar-like material. The pillar-like material is projected from the bottom end of the though-holes having no wired patterns to form the bumps 28 made of the conductive material (Fig.4D).

Copper-plated layers (not shown) may be formed on the top and bottom surfaces of the substrate 22, and an adhesive agent layer 29 is laminated on the bottom surface (the surface having no wired pattern) of the substrate 22 including the projecting bumps 28. A unit print circuit board is constituted by mounting an integrated circuit 31 on the wired patterns 23 of the substrate 22 via a plenty of small solder balls 30.

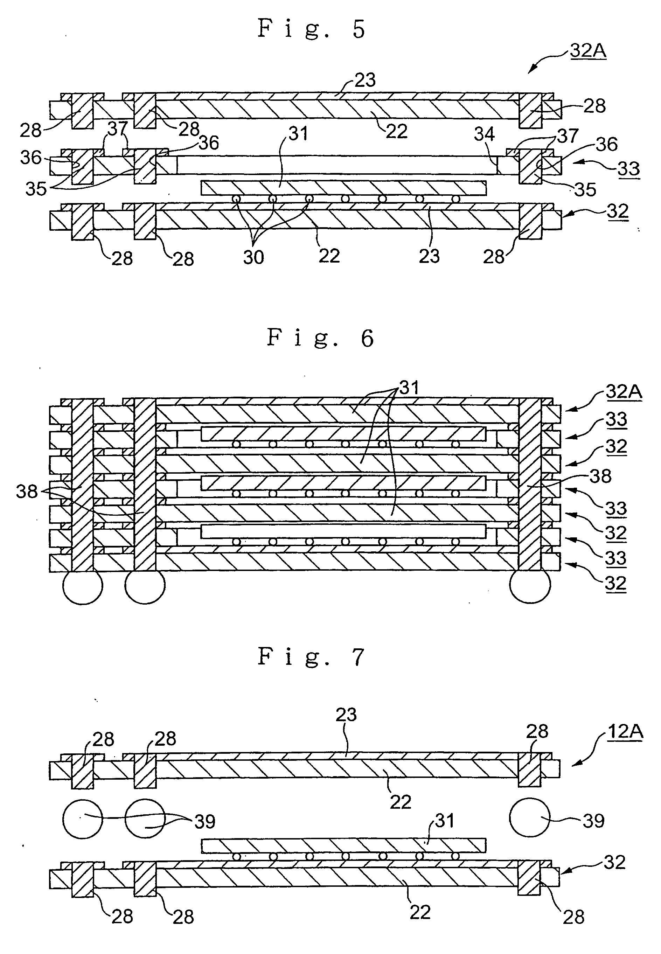

Then, a method of fabricating a stacked CSP using a plurality of the unit print circuit boards will be described referring to Figs.5 and 6. In Figs.5 and 6, the adhesive agent layer 29 of Fig.4 is omitted for simplification of the drawings.

A unit print circuit board 32A positioned in the upper part of Fig.5 has the same configuration as the unit print circuit board 32 of Fig.4 except for including no integrated circuit board, and a unit print circuit board 32 positioned in the lower part has the same configuration as the unit print circuit board 32 of Fig.4.

A stacking frame 33 is sandwiched between both of the unit print circuit boards 32 and 32A. The overall contour of the stacking frame 33 is nearly the same as the shapes of the both unit print circuit boards 32 and 32A, and includes an inward aperture 34 larger than the integrated circuit 31.

Through-holes 36 filled with conductive materials 35 having nearly the same shapes as those of the bumps 28 are formed at the positions of the stacking frame 33 corresponding to the bumps 28 of the unit print circuit board 32. The conductive material 35 projects downward similar to the bump 28 and penetrates through the adhesive agent layer 37 on the top surface. The formation of the through-holes 36 of the stacking frame filled with the conductive material 35 is preferably conducted in a single operation in which the aperture formation and the material filling are performed by using a punch, similarly to the bump formation in Fig.4.

Under the uppermost unit print circuit board 32A, the three stacking frames 33 and the three unit print circuit board 32 are alternately positioned. A pressure is exerted thereto in the vertical direction under heating to melt and integrate the bump 28 of the unit print circuit board 32 and the conductive materials 35 of the stacking frame, thereby forming a longitudinally extending connecting material 38 to electrically connecting the respective unit print circuit boards 32. In this manner, the fabrication of the CSP is accomplished.

In this embodiment, the productivity of the unit print circuit board and eventually the productivity of the CSP are increased different from those of the conventional method in which a though-hole is once formed and then the through-hole is filled by means of plating, because the bump filling into the through-holes 26 and 27 of the unit print circuit board 32 is conducted in the single operation using the punch.

In the present invention, the use of the stacking frame is not essential, and a similar effect can be obtained by, for example as shown in Fig.7, placing the number of solder balls 39 in the positions corresponding to the conductive materials 35 in the stacking frame of Fig.5. Also in this case, the productivity of the unit print circuit board and eventually the productivity of the CSP are increased because the bump filling into the through-holes 26 and 27 of the unit print circuit board 32 is conducted in the single operation using the punch.

Although Examples of fabricating the print circuit board and the CSP in accordance with the present invention will be described, the present invention shall not be restricted thereto.

### [Example 1]

A conductor wired layer having bump was fabricated with procedures shown in Fig.2.

A plurality of openings having a diameter of about 100 µm were perforated through a copper foil (conductor wired layer) having a thickness of 18 µm by using a punch having a diameter of about 100 µm. On the copper foil was superposed a copper foil (conductor layer for forming bump) having a thickness of about 130 µm. The copper foil (conductor layer for forming bump) was punched at the positions corresponding to the respective openings by using the above punch such that the copper foil is entered into the openings to be projected from the bottom edge of the openings and to form bumps, thereby obtaining a conductor wired layer with bumps. Lengths of the downward projection of the bumps were not uniform in the range of 100 to 130 µm.

The conductor wired layer was caulked by using an ordinary caulking machine such that the lengths of the downward projection of the bumps were adjusted to be about 100 µm and the top surface of the bumps and the top surface of the conductor wired layer were aligned.

Then, the conductor wired layer was dipped in a plating bath of copper sulfate (CuSO₄ = 200g/liter) containing a leveling agent and a brightening agent. After the current flowing for 81 seconds at 30°C, a copper-plated layer having a thickness of about 3 µm was formed on the entire surface of the conductor wired layer with bumps.

The conductor wired layer with bumps thus fabricated was adhered to an insulation substrate having through-holes by using an adhesive agent available from Dow Corning Toray Silicone Co., Ltd., thereby obtaining a print circuit board.

Since, in the print circuit board thus fabricated, only the plurality of the bumps other than the conductor wired layer itself were present on the conductor wired layer on which the wired pattern was to be formed, and the positions of the bumps were fixed and easily and visibly confirmed, the wired patterns were formed much more definitely than in the conventional method.

### [Example 2]

A polyimide film (trade name: Espanex, available from Nippon Steel Chemical Co., Ltd.) substrate with a width of 35 mm and a thickness of 50 µm having a copper foil with a thickness of 18 *µ*m laminated on its one surface was used. After a desired wired pattern was formed on the surface of the polyimide film substrate by etching the copper foil, annealed oxygen free high conductivity copper having a plate-like shape was positioned above the substrate.

After punches having a diameter of 80 µm the same as a scheduled diameter of bumps made of the oxygen free high conductivity copper were placed at the positions corresponding to the bump formation on the substrate, the punches were strongly pressed downward for hollowing out the plate-like oxygen free high conductivity copper in the column shape followed by a similar hollow-out of the substrate to form though-holes. The through-holes were immediately filled with the hollowed oxygen free high conductivity copper to project the bottom end of the filled oxygen free high conductivity copper by 20 µm from the surface having no wired pattern thereby forming the bumps.

After copper was plated by 3 µm on the surface without the wired pattern including the projecting bumps followed by plating of nickel (1.5 µm) and gold (0.15 µm) thereon, an integrated circuit was mounted in flip-flop. A unit print circuit board was fabricated by laminating, on the whole surface thereof, an adhesive agent having a thickness of 50 µm available from Dow Corning Toray Silicone Co., Ltd.

A stacking frame was fabricated as follows.

Opening larger than the outer diameter of the above integrated circuit were perforated in the center of the Espanex having a width of 35 mm the same as that of the substrate. The adhesive agent was applied to a position of the stacking frame corresponding to the bumps, and similarly to the case of the substrate, through-holes having a diameter of 80 µm were perforated and immediately thereafter the through-holes were filled with annealed oxygen free high conductivity copper to project the oxygen free high conductivity copper from the bottom surface by 20 µm, thereby forming the stacking frame. After the projected surface was plated with copper by 3 µm followed by tin plating by 0.5 µm, an adhesive agent was laminated on the whole surface having the projection by a thickness of 50 µm.

After the four unit print circuit boards thus fabricated (and one unit print circuit board having no integrated circuit) and the four stacking frames were alternately stacked, the unit print circuit boards and the stacking frames were adhered with heating at 400°C under pressure by means of the alloy formation between the tin and the gold and the adhesive agent on the bump, thereby providing a CSP. During the CSP fabrication, neither through-hole formation by means of laser processing nor bump formation by means of electrolytic copper plating was necessary, and the bump could be formed in the single operation. Accordingly, the length of time for the operation was significantly reduced.

### [Comparative Example 1]

A CSP was fabricated in accordance with Example 1 except that after the through-holes were perforated through the respective unit print circuit boards and the stacking frames by using the punch, the plate-like annealed oxygen free high conductivity copper was placed above the through-holes and the oxygen free high conductivity copper was hallowed out by using the punch to be filled in the through-holes. In this Comparative Example, neither through-hole formation by means of laser processing nor bump formation by means of electrolytic copper plating was necessary.

The mechanical strengths of the CSPs fabricated in Example 2 and Comparative Example 1 were measured, and there was no difference between them. It was apparent that no disadvantage arose even if the length of time for operation was significantly reduced by forming the bump by means of the single punching as Example 2.

## Claims

1. A print circuit board comprising
an insulation substrate having through-holes perforated therethrough;
an implanting material filled in the through-holes;
wired patterns formed on both surfaces of the insulation substrate and electrically connected with each other by the implanting material; and
a conductor wired layer, one surface of which is electrically connected to the implanting material and adhered to the insulation substrate, having a bump penetrating from the one surface thereof to the other surface thereby forming a projection on the other surface.

2. A conductor wired layer for a print circuit board comprising a conductor wired layer and a bump which penetrates from one surface of the conductor wired layer to the other surface thereby forming a projection on the other surface.

3. The conductor wired layer for the print circuit board as claimed in claim 1 or 2, wherein a conductor of the conductor wired layer is a metal, an alloy or a cladding material.

4. The conductor wired layer for the print circuit board as claimed in any one of claims 1 to 3, wherein a plated layer is formed on the bump and/or the conductor wired layer.

5. A print circuit board comprising
an insulation substrate having through-holes perforated therethrough;
an implanting material filled in the through-holes;
wired patterns formed on both surfaces of the insulation substrate and electrically connected with each other by the implanting material; and
a conductor wired layer and a resin layer adhered to the conductor wired layer having a bump penetrating from the conductor wired layer to the resin layer thereby forming a projection on the surface of the resin layer;
the conductor wired layer being bonded to the insulation substrate such that the conductor wired layer is electrically connected to the implanting material.

6. A conductor wired layer for a print circuit board comprising a conductor wired layer, a resin layer adhered to the conductor wired layer and a bump which penetrates from the conductor wired layer to the resin layer thereby forming a projection on the surface of the resin layer.

7. The conductor wired layer for the print circuit board as claimed in claim 5 or 6, wherein a conductor of the conductor wired layer is a metal, an alloy or a cladding material.

8. The conductor wired layer for the print circuit board as claimed in any one of claims 5 to 7, wherein a plated layer is formed on the bump and the conductor wired layer.

9. A method for fabricating a conductor wired layer for a print circuit board comprising the steps of
forming an opening through a conductor wired layer;
adhering a conductor layer for forming a bump on one surface of the conductor wired layer;
entering the conductor layer for forming the bump in the opening for filling the opening therewith; and
projecting the conductor layer for forming the bump from the other surface of the conductor wired layer to form a bump.

10. A method for fabricating a conductor wired layer for a print circuit board comprising the steps of
adhering a conductor layer for forming a bump on one surface of a conductor wired layer;
punching the conductor layer for forming the bump and the conductor wired layer to form an opening and to simultaneously fill the opening with the conductor layer for forming the bump; and
projecting the conductor wired layer for forming the bump from the other surface of the conductor wired layer to form a bump.

11. The method for fabricating the conductor wired layer for the print circuit board as claimed in claim 9 or 10, wherein a plurality of the openings and of the bumps are formed, and the plurality of the bumps are caulked to make heights of the bumps uniform.

12. The method for fabricating the conductor wired layer for the print circuit board as claimed in any one of claims 9 to 11, wherein, after the formation of the bump, a plated layer is formed on the bump and the conductor wired layer.

13. A multi-layered print circuit board comprising a plurality of the print circuit boards claimed as claim 1 stacked with one another.

14. A method of fabricating the print circuit board claimed as claim 1, wherein the implant material is selected from a group consisting of oxygen free high conductivity copper, phosphorous deoxidized copper and tough pitch copper.

15. A method of fabricating a CSP comprising the steps of:
placing a conductive material for forming a bump near a substrate of a print circuit board;
punching the conductive material and the substrate, simultaneously with the punching, to form though-holes in the substrate and to fill the through-holes with the conductive material, thereby fabricating a unit print circuit board having a desired number of bumps in the substrate;
stacking a plurality of the unit print circuit boards sandwiching connecting members; and
pressing the stacked unit print circuit boards under heating.

16. The method as claimed in claim 15, wherein the though-hole formation and the through-hole filling with the conductive material are simultaneously conducted by means of punching using a punch.

17. The method as claimed in claim 15 or 16, wherein a plurality of the bumps of the unit print circuit board project in the same direction.

18. The method as claimed in any one of claim 15 to 17, wherein the conductive material for forming the bump is selected from a group consisting of oxygen free high conductivity copper, phosphorous deoxidized copper and tough pitch copper.
